# EUROPEAN PATENT APPLICATION

(11) **EP 1 655 785 A1**
(43) Date of publication of application: **10.05.2006**
(21) Application number: 04425832.5
(22) Date of filing: 09.11.2004
(51) Int. Cl.: H01L 33/00

(54) **Light emitting ambipolar device**

(71) Applicant: C.R.F. Società Consortile per Azioni, 10043 Orbassano (TO) (IT)
(72) Inventor: Perlo, Piero, 10043 Orbassano (Torino) (IT); Li Pira, Nello, 12045 Fossano (Cuneo) (IT); Paderi, Marzia, 10127 Torino (IT); Monferino, Rossella, 10129 Torino (IT); Lambertini, Vito, 10049 Giaveno (Torino) (IT); Repetto, Piermario, 10145 Torino (IT)
(74) Representative: Notaro, Giancarlo

(57) **Abstract**

A light emitting ambipolar device of the type comprising at least a first (13; 33) and a second (14; 34) main electrode in electrical contact through a light emitting region (12; 22; 32; 42) comprising at least one carrier recombination layer (19) and further comprising one or more further electrodes (15, 16; 35, 36; 45, 46) for controlling recombination in said light emitting region (12; 22; 32; 42) characterised in that said first (13; 33) and second (14; 34) main electrode and said one or more further electrodes (15, 16; 35, 36; 45, 46) for controlling the recombination in said light emitting region (12; 22; 32; 42) are arranged in planar configuration relative to said region (12; 22; 32; 42), said one or more further electrodes (15, 16; 35, 36; 45, 46) for controlling the recombination identifying one or more insulating channels (17, 18; 27, 28; 37, 38) with respect to said light emission (12; 22; 32; 42) comprising said at least one carrier recombination layer (19).

## Description

The present invention relates to a light emitting ambipolar device of the type comprising at least a first and a second main electrode in electrical contact through a light emitting region comprising at least one carrier recombination layer and further comprising one or more furhter electrodes for controlling recombination in said light emitting region.

In the prior art, field effect transistors (FET) of the so-called ambipolar type, which operate as channel p or channel n devices, depending on the polarity assumed by the voltage at one control electrode, or gate, and can operate in bipolar or mixed mode. In these devices, both electrons and holes are injected separately by the source and drain electrodes. The injection in equal parts of electrons and holes can be controlled by appropriately regulating the gate electrode and operating on the drain-source voltage. This leads to the formation of a pn junction within the device and therefore the formation of excitons is expected, whose recombination can give rise to radiative transitions, i.e. to the emission of light.

From the publication *"A Light-Emitting Field-Effect Transistor"* by J.H. Schoen, A, Dodabalapur, Ch. Kloc, B. Battlogg, Science, Vol. 2903, 3 November 2000, for example, is known a similar electroluminescent ambipolar device, which uses an organic semiconductor, α-sexitiophene, as a layer for recombination. However, use of this particular type of semiconductor determines the spectrum of the radiation emitted by electroluminescence. Moreover, this device, making use of a FET structure, requires particular care to obtain a good ohmic contact in the manufacture of the source and drain electrodes, as well as a high quality gate electrode.

The object of the present invention is to provide a solution capable of effectively and flexibly exploiting the ambipolar injection of carriers to obtain light emission, by means of a device that is simple to manufacture with respect to known solutions.

According to the present invention, said object is achieved thanks to a light emitting device having the characteristics specifically set out in the annexed claims.

As shall be readily apparent, in the preferred embodiment of the invention the light emitting ambipolar device of the type comprising at least a first and a second main electrode in electrical contact through a light emitting region comprising at least one carrier recombination layer and further comprising one or more further electrodes for controlling the recombination in said light emitting region, said first and second main electrode and said one or more additional electrodes for recombination control, in said light emitting region, being arranged in a planar configuration relative to said region, said one or more further electrodes for the recombination control identifying one or more insulating channels with respect to said light emitting region comprising the carrier recombination layer. According to a further aspect of the invention, said carrier recombination layer is at least in part a percolated layer.

The invention shall now be described with reference to the accompanying drawings, provided purely by way of non limiting example, in which:
- Figure 1 is a schematic plan view of a first embodiment of the electroluminescent device according to the invention;
- Figure 2 is a diagrammatic representation of energy bands relating to an operating phase of the device according to the invention;
- Figure 3 is a schematic plan view of the device according to the invention in this further phase of operation;
- Figure 4 is a schematic plan view of a second embodiment of the electronic device according to the invention;
- Figure 5 is a schematic plan view of a third embodiment of the electronic device according to the invention;
- Figure 6 is a schematic plan view of a fourth embodiment of the electronic device according to the invention.

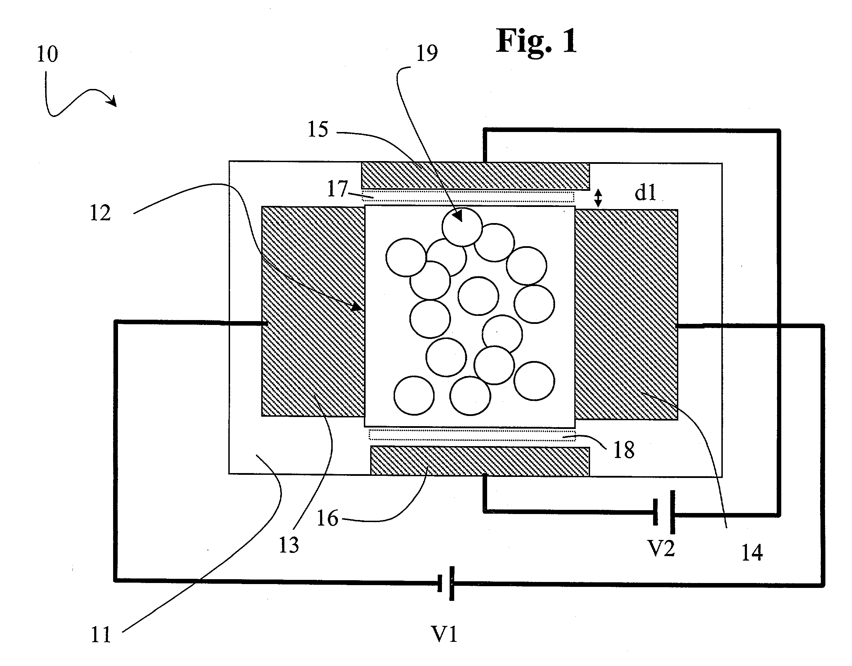

Figure 1 shows a light emitting device, in particular electroluminescent, according to the invention, globally designated with the reference number 10.

Said electroluminescent device 10 comprises a substrate 11 made of insulating material, preferably of silicon dioxide, SiO₂ or alumina, Al₂O₃. On this substrate 11 is deposited an electroluminescent region 12, of substantially rectangular shape. Said electroluminescent region 12 is provided with electrical contacts embodied by a first main electrode 13 and a second main electrode 14, made of gold, of the planar type. The first main electrode 13 and the second main electrode 14 are positioned respectively along two opposite sides of the electroluminescent region 12 of rectangular shape, in contact with said sides. On the substrate 11, along an axis perpendicular to the one identified by the first main electrode 13 and by the second main electrode 14, are also deposited a first injection electrode 15 and a second injection electrode 16, also of the planar type and positioned at the sides of the electroluminescent region 12 at a distance d1, in such a way as to identify respect to said sides two respective insulating channels 17 and 18. Said distance d1 is smaller than 500 nm. The function of the insulating channels 17 and 18 is to prevent the formation of a direct electrical path between the injection electrodes 15 and 16 and the main electrodes 13 and 14. Between the first main electrode 13 and the second main electrode 14 is applied a bias voltage V1, whilst between the injection electrodes 15 and 16 is applied an injection voltage V2.

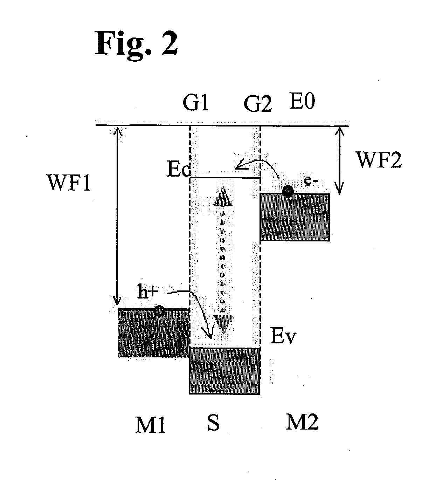

From the distance d1, which corresponds to the width of the insulating channels 17 and 18, depends the value of the injection tension V2 to be applied to favour the transfer of carriers, i.e. electrons and holes, inside the part of electroluminescent region 12 where the recombination between the carriers takes place, according to a recombination scheme that shall be described in detail hereafter with reference to Figure 2.

The dimensions and the distances between the injection electrodes 15 and 16, in any case, can be selected as a function of the application voltage and of the recombination zone in which the emission of light takes place

The electroluminescent region 12, according to an aspect of the invention, comprises a thin percolated layer 19. The systems composed by a chaotic distribution of dielectric and metal are known with the name of non continuous films or percolated structures.

Said percolated structures, when they are in the form of films or thin layers, show electronic transport properties different from the properties a massive structure would have and, in particular, a type of transport able to be associated to conduction by percolation.

In particular, the percolated layer 19 which embodies the electroluminescent region 12 is composed by a first metal M1 and by a second metal M2, as well as by an electroluminescent material S including a semiconductor able to allow radiative transitions hence to operate as a light emitter. The first metal M1 and the second metal M2 are selected in such a way that there are respective extraction work functions, mutually different in order to create such a local electrical field as to favour the injection of the electroluminescent material S inside the semiconductor. In a preferred form, said difference of the work functions of the first metal M1 and of the second metal M2 is at least 1 eV. By way of example, the first metal M1 can be selected in a group with other values of work function (between 4 and 5 eV) such as gold, silver, platinum, cobalt, copper, whilst the second metal M2 can be selected in a group of metals with low work function such as magnesium, calcium, samarium, yttrium, i.e. for which the work function value is indicatively lower than 3.4 eV. In regard to the selection of an emitter material S, inorganic or organic semiconductors are proposed with band gap in the visible region. In the percolated layer 19 to said emitter material S can be added a further semiconductor with the purposes of serving as transport material for electrons, or, dually, for holes.

Figure 2 shows a diagram representing the arrangement of the energy levels at the interface of first metal M1 - emitter material S - second metal M2 in the absence of applied electrical field.

The reference number EO designates a vacuum energy level, whilst WF1 designates a first work function of the first metal M1, i.e. the distance in energy between the conduction band of the metal M1 and the vacuum energy level E0. In the same way, the reference WF2 designates a second work function of the second metal M2.

The diagram of Figure 2 shows the existence of two junctions, a first junction G1, first metal M1 - semiconductor S and a second junction G2, semiconductor - second metal M2, whereto are associated different energy gaps. Because of the difference between the work functions WF1 and WF2 of the two metals M1 and M2, an electrical field is generated which favours charge transportation. Applying the voltage V1 to the ends of the main electrodes 13 and 14, the energy levels in proximity to the junctions G1 and G2 are curved and the injection of electrons e- is facilitated between the second metal M2 with low work function WF2 and a conduction band Ec of the semiconductor which constitutes the emitter material S, as well as the injection of holes h+ from the first metal M1 with high work function WF1 in a valence band Ev of the emitter material S itself. The creation of an electron-hole pair within the semiconductor that constitutes the emitter material S generates a recombination whereto is associated a consequent radiative transition with emission of a photon, i.e. emission of light.

The presence of the further injection electrodes 15 and 16 determines an operation of the proposed device according to an ambipolar characteristic.

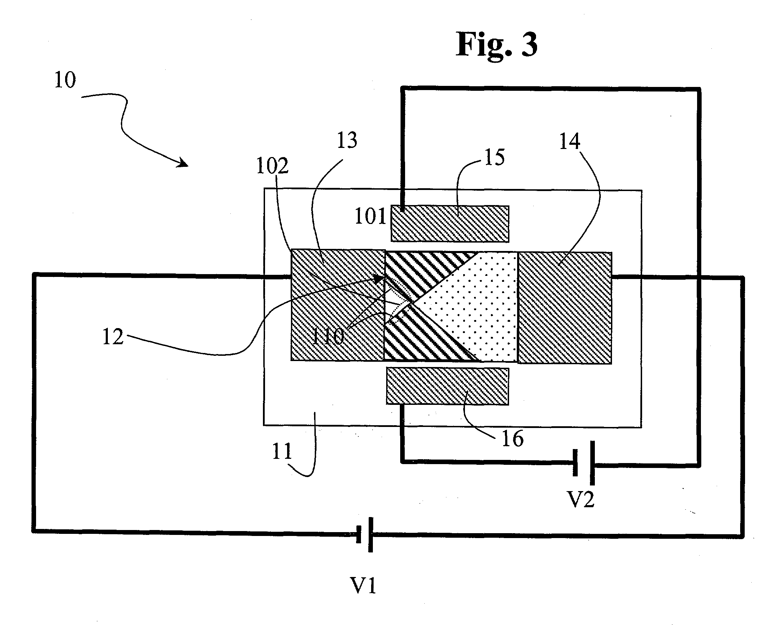

Said ambipolar operation is represented schematically in Figure 3, where the electroluminescent device 10 of Figure 1: in relation to the polarity of the field applied by means of the injection voltage V2 between said injection electrodes 15 and 16, through the generation of two separate regions of type n, 101, and of type p, 102 within the percolated layer 19 of the region 12, and injection of a current of electrons and holes is enabled between the two main electrodes 13 and 14, so a zone of greater recombination 110 is determined. The height of the barrier formed at the functions G1 and G2, first metal-semiconductor interface and semiconductor-second metal interface respectively, regulates the injection of holes in one case and of electrons in the other. The additional electrical field induced externally between the injection electrodes 15 and 16 and a main electrode acts on these barriers facilitating the injection inside the semiconductor which constitutes the emitter material S. Moreover, the balancing and the concentration in the injection of electrons and of holes can be modulated regulating the polarisation voltage V1 and injection voltage V2 applied between the two pairs of electrodes, thus displacing inside the region 12 the zone of greater recombination 110 of the device.

Control parameters of the electroluminescent devices 10 are therefore the power voltage V1 and the injection voltage V2, as well as the dimensions of the insulating channels 17 and 18, i.e. the distance d1, and the geometry of the electrodes 13, 14, 15 and 16.

The variation of the distance d1 allows to modulate the balancing and concentration of the charges without changing the value of the voltage V1 and V2 applied to the electrodes, but obtaining different field values in the percolated layer 19. Regulating the power voltage V1 and the injection voltage V2, it is possible to modulate the zone 110 of the percolated layer 19 in which recombination is favoured.

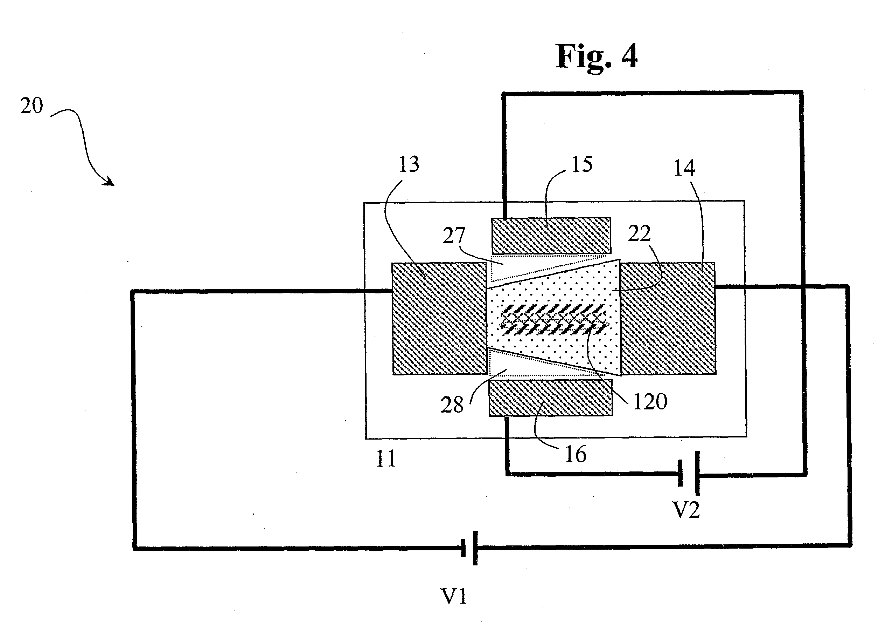

Figure 4 shows an electroluminescent device 20, variant to the electroluminescent device 10 of Figure 1, provided with an electroluminescent region 22 in trapezoid form, the oblique sides of this trapezoid facing the injection electrodes 15 and 16, so the distance d1 between electrode and side of the electroluminescent region 22 varies linearly and, correspondingly, with isolating channels 27 and 28 which are thus identified substantially correspond to right-angled triangle whose height is the maximum distance d1 between electrode and electroluminescent region, as longer cathetus the length of the injection electrode and as hypotenuse the oblique side of the trapezoid constituting the region 12. The part of the electroluminescent region 22 in which the recombination actually takes place is designated by the reference 120.

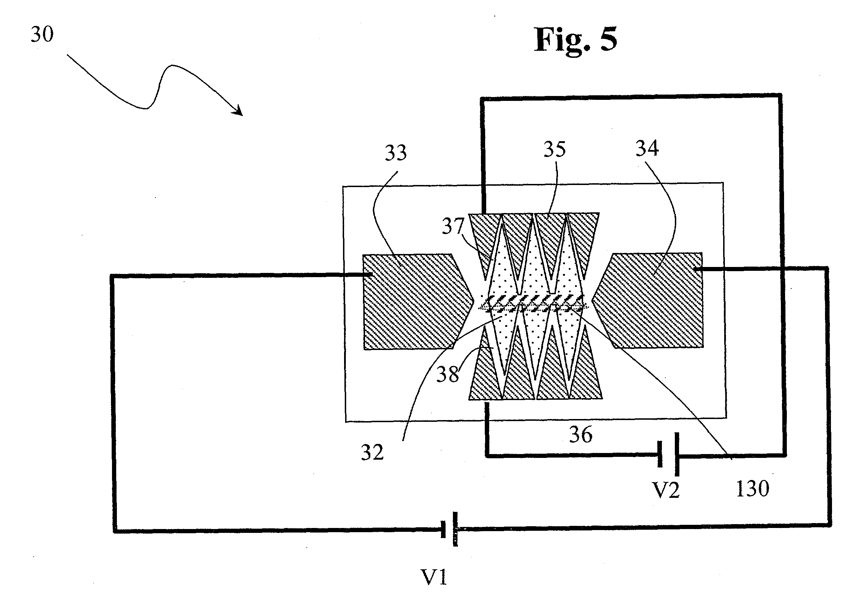

The shape of the electrodes can be optimised to obtain a recombination region effected by the electrical field that is as extensive and uniform as possible. In this regard, Figure 5 shows an additional embodiment 30 of the electroluminescent device according to the invention that comprises injection electrodes 35 and 36 with spikes, in such a way as to intensify the electrical field at the singularities. In the device 30 of Figure 5 are also shown main electrodes 33 and 34 similarly provided with spikes on a perpendicular axis to the tips of the electrodes 35 and 36. A zone of greater recombination 130 in an electroluminescent region 32, shaped with complementary spikes to the injection electrodes 35 and 36 in such a way as to form an interleaved structure and maintaining insulating channels 37 and 38 with separation zigzag, is particularly narrow and located on the axis defined by the main electrodes 33 and 34.

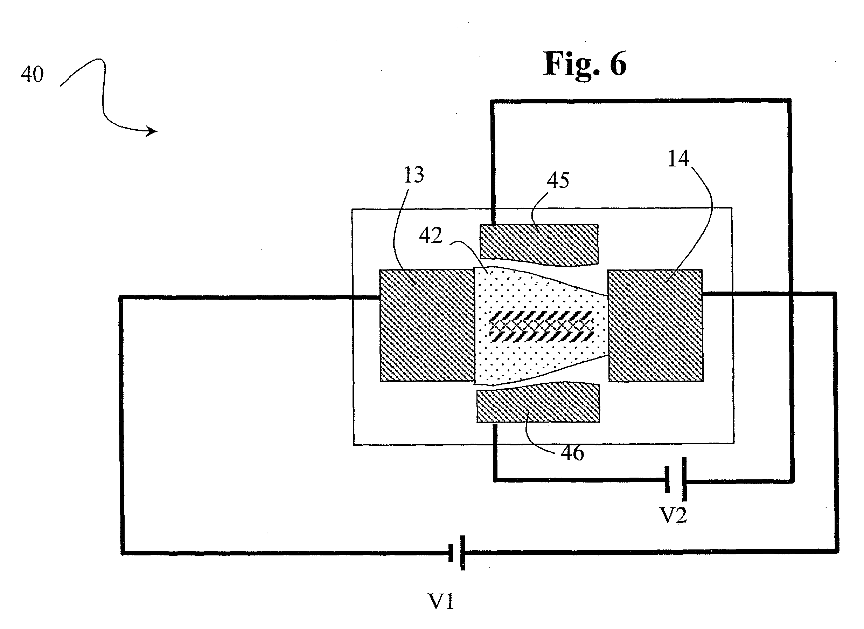

Figure 6 instead shows an embodiment 40 which comprises injection electrodes 45 and 46 which, towards an electroluminescent region 42, have sides provided with variously curved profiles, which therefore create in the percolated layer of the region 42, having similarly curved sides, electrical fields with variable uniformity.

The applications of the light emitting ambipolar device are mainly in the field of the emission displays for the construction of active or passive matrices composed by devices of the type proposed herein.

For active matrix displays, the starting point is usually a TFT matrix made of amorphous or polycrystalline silicon (high temperature or low temperature); active matrices of this type have been developed and prevalently used for liquid crystal displays. The advantages of an active matrix are readily apparent: the application of low driving voltages (at which the material has greater efficiency), the removal of the patterning of the metallic cathode (which is problematic on very small line dimensions) and the consequent possibility of obtaining displays with high multiplexing (VGA, SVGA, XGA, SXGA, ...) .

A passive matrix display is composed by a row and column structure: the relative simplicity of the passive matrix display (without transistors) is associated to the problem of driving the rows and columns to create an image. With a multiplexing of 1: N one pixel is applied for times equal to 1/N at the cycle time necessary to activate all pixels, so its luminance must be N times greater than the one perceived by the eye in the cycle. The load drop along the line and the short duration of the pulses make it necessary to apply a driving voltage that is N times higher. Therefore, a high current density is necessary to maintain constant the visual perception of the pixel. The voltage increase entails a reduction in the average working life of the devices and renders critical the choice of the active material and of the cathode.

The layers with percolated structure which compose the electroluminescent region can be deposited by means of different deposition techniques, such as thermal evaporation, electron beam, sputtering, cluster beam deposition (PMC- Pulsed Microplasma Cluster-) on substrates of glass, silicon with orientation <100> or other dielectric and can be composed by metallic, dielectric or semiconductor material.

The level of percolation is defined as the point in which, during the deposition process, the material passes from an isolating behaviour to a conducting behaviour. This takes place because, during the deposition process, metal clusters are formed which, growing and aggregating by thermal agitation and Coulombian attraction, form an irregular structure composed by conductor nanowires. Proceeding with the deposition, a continuous film with metallic characteristics is constituted. The thickness at which the percolation effect is present ranges from 2 to 10 nanometres, depending on substrate temperature, the deposition parameters and the chosen metal, which, in the case of metals, can be copper, silver, gold or aluminium.

The preparation of metallic film at the percolation level can also take place by cluster deposition: in particular through PMCS ("Pulsed Microplasma Cluster Source") sources, metal/semiconductor matrices are obtained that are composed by an ordered or chaotic distribution of cluster. Said technology generates clusters through the condensation, within a vacuum chamber known as pre-expansion, of vapours of atoms previously "extracted" by an impulse of the plasma from a target; said clusters are subsequently accelerated by means of a nozzle, with ultrasonic acceleration, and deposited on glass or quartz substrates inside a deposition chamber. The simultaneous use in the deposition chamber of thermal, e-beam, sputtering or CVD evaporation techniques allows to obtain three-dimensional films and matrices containing inclusions of clusters of a different nature. Moreover, the application of appropriate templates on the substrate allows the deposition of orderly matrices of clusters, spaced according to the pitch of the template itself.

The solution described above allows to achieve considerable advantages with respect to known solutions.

The light emitting ambipolar device according to the invention allows effectively and flexibly to exploit the ambipolar injection of carriers to obtain light emission, by means of a device that is simple to obtain, because it adopts a planar arrangement.

The adoption of the percolated structure, in addition to enabling electroluminescence, allows to vary numerous parameters in the composition of the layer, obtaining devices with different characteristics in flexible fashion. In the same way, the planar arrangement with the insertion of insulating channels allows to operate on additional control parameters such as the thickness of said insulating channels or the shape of the electrodes, without necessarily changing power voltages. This advantageously allows to apply the electroluminescent device in active or passive matrix structures for displays.

Naturally, without altering the principle of the invention, the construction details and the embodiment may vary widely from what is described and illustrated purely by way of example herein, without thereby departing from the scope of the present invention.

For example, the number of injection electrodes may be different. In particular, the injection electrode can also be only one.

In the same way, the metal-semiconductor percolated systems can contain more than two metals and/or more than one semiconductor.

The interpercolated system can be replaced with an organic layer for application in the field of lasers; in this case, the pumping area is controlled by regulating the voltage applied to the system of planar electrodes.

## Claims

1. A light emitting ambipolar device of the type comprising at least a first (13; 33) and a second (14; 34) main electrode in electrical contact through a light emitting region (12; 22; 32; 42) comprising at least one carrier recombination layer (19) and further comprising one or more further electrodes (15, 16; 35, 36; 45, 46) for controlling recombination in said light emitting region (12; 22; 32; 42) **characterised in that** said first (13; 33) and second (14; 34) main electrode and said one or more further electrodes (15, 16; 35, 36; 45, 46) for controlling the recombination in said light emitting region (12; 22; 32; 42) are arranged in planar configuration relative to said region (12; 22; 32; 42), said one or more further electrodes (15, 16; 35, 36; 45, 46) for controlling the recombination identifying one or more insulating channels (17, 18; 27, 28; 37, 38) with respect to said light emitting region (12; 22; 32; 42) comprising said at least one carrier recombination layer (19).

2. Device as claimed in claim 1, **characterised in that** all or part of said carrier recombination layer (19) is a percolated layer.

3. Device as claimed in claim 2, **characterised in that** said percolated layer (19) comprises a first metal (M1) associated to a first work function (WF1), a second metal (M2) associated to a second work function (WF2) and at least one light emitting semiconductor (S).

4. Device as claimed in at least one of the claims from 1 to 3, **characterised in that** in said light emitting region (22) has trapezoidal shape.

5. Device as claimed in at least one if the claims from 1 to 3, **characterised in that** said one or more additional electrodes (35, 36) and/or said first main electrode (33) and/or second main electrode (34) comprise spikes.

6. Device as claimed in claim 4, **characterised in that** in said one or more further electrodes (45, 46) and/or said region (46) have variously curvilinear shape where they face each other.

7. Device as claimed in one or more of the previous claims, **characterised in that** said first metal (M1) is selected in a group comprising gold, silver, platinum, cobalt, copper, and said second metal (M2) is selected in a group comprising magnesium, calcium, samarium, yttrium.

8. Device as claimed in one or more of the previous claims, **characterised in that** the difference of the work functions of the first metal (M1) and of the second metal (M2) is at least 1 eV.

9. Device as claimed in one or more of the previous claims, **characterised in that** said percolated layer (19) comprises an additional semiconductor to serve as transport material for electrons or holes.

10. Device as claimed in claim 1, **characterised in that** said all or part of said at least one recombination layer (19) is an organic layer for application in the field of lasers.

11. A display device **characterised in that** it comprises a matrix of light emitting ambipolar devices as claimed in one or more of the claims 1 through 9.
